(19) Europäisches Patentamt
European Patent Office
Office européen des brevets

(11) **EP 3 739 352 A1**

(12) **EUROPÄISCHE PATENTANMELDUNG**

(43) Veröffentlichungstag:
**18.11.2020 Patentblatt 2020/47**

(51) Int Cl.:
***G01R 33/3875*** (2006.01)   ***G01R 33/385*** (2006.01)
***G01R 33/48*** (2006.01)

(21) Anmeldenummer: **19174823.5**

(22) Anmeldetag: **16.05.2019**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Healthcare GmbH**
**91052 Erlangen (DE)**

(72) Erfinder:
• **Whelan, Brendan**
  **90762 Fürth (AU)**
• **Leghissa, Martino**
  **91369 Wiesenthau (DE)**
• **Rohdjeß, Heiko**
  **91091 Grossenseebach (DE)**

(54) **MAGNETRESONANZANLAGE UND VERFAHREN ZUM AUSGLEICH VON GRUNDMAGNETFELDINHOMOGENITÄTEN ERSTER ORDNUNG IN EINEM UNTERSUCHUNGSBEREICH DER MAGNETRESONANZANLAGE**

(57)   Die Erfindung betrifft eine Magnetresonanzanlage (7) und Verfahren zum Ausgleich von Grundmagnetfeldinhomogenitäten erster Ordnung in einem Untersuchungsbereich (14) der Magnetresonanzanlage (7), wobei die Magnetresonanzanlage (7) eine Shimspulenvorrichtung (15) und eine Gradientenspulenvorrichtung (12) umfasst, wobei die Shimspulenvorrichtung (15) dazu ausgebildet ist, Grundmagnetfeldinhomogenitäten erster Ordnung in einem Untersuchungsbereich (14) der Magnetresonanzanlage (7) auszugleichen, wobei die Shimspulenvorrichtung (15) zumindest ein Shimspulenelement (41) umfasst, wobei die Gradientenspulenvorrichtung (12) in einer Gradientenspulenschicht (16) angeordnet ist, dadurch gekennzeichnet, dass in der Gradientenspulenschicht (16) zusätzlich zur Gradientenspulenvorrichtung (12) zumindest ein Teil des zumindest einen Shimspulenelements (41) angeordnet ist.

FIG 2

EP 3 739 352 A1

**Beschreibung**

Die vorliegende Erfindung betrifft eine Magnetresonanzanlage und ein Verfahren zum Ausgleich von Grundmagnetfeldinhomogenitäten erster Ordnung in einem Untersuchungsbereich der Magnetresonanzanlage.

Bei einer Magnetresonanzuntersuchung (MR-Untersuchung) wird häufig ein Untersuchungsobjekt, insbesondere ein Patient, einem relativ starken Grundmagnetfeld, beispielsweise 1,5 oder 3 oder 7 Tesla, ausgesetzt. Dies kann durch eine Positionierung des Untersuchungsobjektes innerhalb eines Aufnahmebereiches einer Magnetresonanzanlage ermöglicht werden. Durch die Positionierung des Untersuchungsobjektes innerhalb des relativ starken Grundmagnetfeldes kommt es üblicherweise zu einer parallelen oder anti-parallelen Ausrichtung von Kernspins, insbesondere Wasserprotonenspins, zur Richtung des Grundmagnetfeldes innerhalb des Untersuchungsobjektes. Dabei kommt es zu einer Präzession der Kernspins um die Richtung des Grundmagnetfeldes herum mit einer Larmorfrequenz. Die Larmorfrequenz ist hierbei abhängig von einer Art der Kerne sowie von der magnetischen Flussdichte des Grundmagnetfeldes.

Da die parallele Ausrichtung der Kernspins zum Grundmagnetfeld einen thermischen und energetischen Gleichgewichtszustand darstellt, kommt es häufig zu einer parallelen Ausrichtung einer Netto-Magnetisierung zum Grundmagnetfeld. Hierbei ergibt sich die Netto-Magnetisierung, im Folgenden auch als Magnetisierung bezeichnet, als effektive makroskopische Magnetisierung der einzelnen magnetischen Dipolmomente der Kernspins.

Mittels einer Gradientenspuleneinheit können zusätzliche und räumlich variierende Magnetfelder, insbesondere Magnetfeld-Gradienten, ausgegeben werden. Durch eine folglich positionsabhängige Larmorfrequenz entlang der räumlichen Dimension der Magnetfeld-Gradienten kann somit eine Ortskodierung innerhalb eines Untersuchungsbereiches ermöglicht werden. Mittels einer Hochfrequenz-Antenneneinheit können Hochfrequenz-Pulse (HF-Pulse), beispielsweise Anregungspulse oder Sättigungspulse, ausgegeben werden. Sofern ein HF-Puls resonant mit der Larmorfrequenz der Kernspins ist, kann eine Anregung, insbesondere Auslenkung, der Kernspins aus einer Gleichgewichtslage heraus erfolgen. Die dabei entstehende transversale Komponente der Präzession der Netto-Magnetisierung um die Richtung des Grundmagnetfeldes herum kann zu einer Induktion in der HF-Antenneneinheit führen. Dabei nimmt die transversale Komponente der Netto-Magnetisierung insbesondere exponentiell mit einer transversalen Relaxationszeitkonstante ab. Hierbei kann ein MR-Signal, insbesondere ein Free-Induction-Decay (FID), mittels der HF-Antenneneinheit detektiert werden. Zudem erfolgt eine longitudinale Relaxation der Netto-Magnetisierung zurück in den thermischen Gleichgewichtszustand.

Mittels der detektierten MR-Signale, welche insbesondere durch die Ausgabe von Magnetfeld-Gradienten ortskodiert sind, können Magnetresonanz-Bilder (MR-Bilder) des Untersuchungsobjektes rekonstruiert werden.

Werden mehrere MR-Signale nach Ausgabe eines einzelnen Anregungspulses ausgelesen, so kann der zeitliche Verlauf einer Relaxation der Kernspins detektiert werden. Dabei wird die Zeitdauer zwischen der Ausgabe des Anregungspulses und dem Auslesen eines MR-Signals häufig als Echozeit (engl. echo time, TE) bezeichnet.

Häufig wird die Ausgabe mehrerer Magnetfeld-Gradienten, insbesondere entlang verschiedener räumlicher Dimensionen, und von HF-Pulsen in einer Sequenz zusammengefasst, auch Puls-Sequenz oder MR-Sequenz genannt. Die Sequenzen umfassen dabei häufig auch eine zeitliche Abfolge von Auslesefenstern (Analog-to-Digital Conversion, ADC), innerhalb welcher ein Auslesen von MR-Signalen ermöglicht wird.

Bei vielen Bildgebungstechniken mittels einer Magnetresonanzanlage ist die Homogenität des Grundmagnetfeldes im Untersuchungsbereich von entscheidender Bedeutung. Grundmagnetfeldinhomogenitäten können beispielsweise zu Verzerrungen oder Auslöschungen in MR-Bildern führen.

Dabei können die Grundmagnetfeldinhomogenitäten als Folge einer starren Anordnung von Komponenten der Magnetresonanzanlage und/oder durch das Einbringen eines Untersuchungsobjektes, insbesondere einen Patienten, in den Untersuchungsbereich der Magnetresonanzanlage und/oder durch eine Bewegung von Komponenten der Magnetresonanzanlage und/oder durch Einbringen weiterer, insbesondere ferromagnetischer, Objekte in den Untersuchungsbereich entstehen.

Aus dem Stand der Technik ist bekannt, dass die Grundmagnetfeldinhomogenitäten mittels einer Kugelflächenzerlegung in drei Terme erster Ordnung und weitere Terme höherer Ordnungen zerlegt werden können. Dabei kann die Kugelflächenzerlegung insbesondere als eine Entwicklung des Grundmagnetfeldes nach Kugelflächenfunktionen bezeichnet werden. Gleichung (1) zeigt beispielhaft eine Zerlegung des Grundmagnetfeldes $B_z$ in Kugelflächenterme.

$$B_z(\rho, \vartheta, \varphi) = A_0^0 + \sum_{l=1}^{\infty} \left(\frac{\rho}{\rho_0}\right)^l \sum_{m=0}^{l} P_l^m(u)(A_l^m \cos(m\varphi) + B_l^m \sin(m\varphi)) \qquad (1)$$

Hierbei bezeichnen die Koeffizienten $A$ und $B$ jeweils eindeutige harmonische Terme, welche an eine gemessene Karte des Grundmagnetfeldes angepasst werden können. Ferner bezeichnen $P_l^m(u)$ Legendrepolynome, wobei $u = \cos \vartheta$. In einem Kugelkoordinatensystem bezeichnen $\rho$ einen Radius, $\vartheta$ einen Azimutwinkel (mit $0 \leq \vartheta \leq 2\pi$) und $\varphi$ einen Polarwinkel (mit $0 \leq \varphi \leq 2\pi$). Terme erster Ordnung der Kugelflächenzerlegung entsprechen dabei $l$=1. Terme höherer Ordnung der Kugelflächenzerlegung können für $l$>1 bestimmt werden.

Dabei entsprechen die drei Terme erster Ordnung jeweils einem von drei orthogonalen Richtungstermen. Zum Ausgleich der Grundmagnetfeldinhomogenitäten erster Ordnung wird häufig ein Offset-Strom entsprechend den drei orthogonalen Richtungstermen erster Ordnung der Kugelflächenzerlegung ("sphericalharmonics") in die Gradientenspuleneinheit eingespeist. Ein Ausgleich von Grundmagnetfeldinhomogenitäten höherer Ordnung erfolgt häufig mittels einer separaten Shimspulenvorrichtung.

Bekannte Verfahren weisen dabei mehrere Nachteile auf. So können durch die zusätzliche Speisung der Gradientenspuleneinheit mit dem Offset-Strom wiederum "parasitische" Terme höherer Ordnung als Grundmagnetfeldinhomogenität auftreten. Dabei beschreibt die Speisung eines Spulenelementes üblicherweise eine Bestromung des Spulenelementes mit einem elektrischen Strom.

Ferner wird durch die, insbesondere gleichzeitige, Verwendung der Gradientenspuleneinheit zur Ausgabe von Magnetfeld-Gradienten und zur Korrektur von Grundmagnetfeldinhomogenitäten erster Ordnung eine Speisekapazität der einzelnen Verwendungen eingeschränkt.

Der Erfindung liegt daher die Aufgabe zugrunde, eine besonders geeignete Vorrichtung zum Ausgleich von Grundmagnetfeldinhomogenitäten erster Ordnung in einem Untersuchungsbereich einer Magnetresonanzanlage anzugeben.

Gemäß einer ersten Variante einer Magnetresonanzanlage und eines Verfahrens zum Ausgleich von Grundmagnetfeldinhomogenitäten erster Ordnung in einem Untersuchungsbereich der Magnetresonanzanlage wird diese Aufgabe erfindungsgemäß gelöst durch die Merkmale des unabhängigen Anspruchs 1 oder 12. Vorteilhafte Ausführungsformen mit zweckmäßigen Weiterbildungen sind Gegenstand der Unteransprüche.

Danach ist vorgesehen, dass eine Magnetresonanzanlage eine Shimspulenvorrichtung und eine Gradientenspulenvorrichtung umfasst, wobei die Shimspulenvorrichtung dazu ausgebildet ist, Grundmagnetfeldinhomogenitäten erster Ordnung in einem Untersuchungsbereich der Magnetresonanzanlage auszugleichen. Hierbei umfasst die Shimspulenvorrichtung zumindest ein Shimspulenelement. Zudem ist die Gradientenspulenvorrichtung in einer Gradientenspulenschicht angeordnet. Ferner ist in der Gradientenspulenschicht zusätzlich zur Gradientenspulenvorrichtung zumindest ein Teil des zumindest einen Shimspulenelements angeordnet.

Mittels einer Kugelflächenzerlegung der Grundmagnetfeldinhomogenitäten können insbesondere zumindest drei Terme erster Ordnung und weitere Terme höherer Ordnungen abgeleitet werden. Dabei können die drei Terme erster Ordnung insbesondere jeweils einer von drei zueinander orthogonalen Raumrichtungen entsprechen.

Dadurch, dass die Shimspulenvorrichtung dazu ausgebildet ist, die Grundmagnetfeldinhomogenitäten erster Ordnung in dem Untersuchungsbereich der Magnetresonanzanlage auszugleichen, kann insbesondere auf eine zusätzliche Speisung der Gradientenspulenvorrichtung mit einem Offset-Strom verzichtet werden. Hierdurch bleibt die vollständige Speisekapazität der Gradientenspulenvorrichtung zur Ausgabe der Magnetfeld-Gradienten erhalten.

Ferner kann vorteilhafterweise die Entstehung "parasitischer" Grundmagnetfeldinhomogenitäten höherer Ordnung durch den Ausgleich der Grundmagnetfeldinhomogenitäten erster Ordnung mit einer dafür ausgebildeten Shimspulenvorrichtung verhindert werden. Dies wird insbesondere durch die Verwendung der, insbesondere zum Ausgleich der Grundmagnetfeldinhomogenitäten erster Ordnung besonders geeigneten, Shimspulenvorrichtung ermöglicht.

Des Weiteren kann insbesondere bei einer Anordnung der Shimspulenvorrichtung an einer Gradientenspulenvorrichtung, welche eine Abschirmeinheit zur Abschirmung von Magnetfeldern umfasst, auf eine separate Abschirmung an der Shimspulenvorrichtung verzichtet werden.

Der Untersuchungsbereich ist vorteilhafterweise ausgebildet, das Untersuchungsobjekt ganz oder teilweise aufzunehmen. Der Untersuchungsbereich wird beispielsweise durch ein, insbesondere zylindrisches, Gehäuse der Magnetresonanzanlage begrenzt. Insbesondere kann der Untersuchungsbereich als Bohrung (engl. bore) ausgebildet sein.

Das zumindest eine Shimspulenelement ist beispielsweise eine elektrisch leitfähige Struktur, die derart ausgebildet ist, dass bei einem elektrischen Stromfluss durch die elektrische Struktur, insbesondere bei einer Speisung des Shimspulenelements, ein das Grundmagnetfeld homogenisierendes Magnetfeld erzeugt wird.

Die Gradientenspulenvorrichtung ist in einer Gradientenspulenschicht angeordnet. Dabei weist die Gradientenspulenschicht insbesondere eine innere Begrenzungsfläche und eine äußere Begrenzungsfläche auf, welche die Gradientenspulenschicht in radialer Richtung begrenzen. Die Gradientenspulenschicht weist insbesondere eine Dicke auf, welche durch eine radiale Ausdehnung der Gradientenspulenvorrichtung bestimmt wird. Die innere Begrenzungsfläche weist üblicherweise einen kleineren Abstand zum Untersuchungsbereich auf als die äußere Begrenzungsfläche.

Häufig werden zylindrische Tragrohr und/oder Rahmensysteme als tragender Bestandteil für Gradientenspulenvorrichtungen genutzt. Dabei umfasst die Gradientenspulenschicht insbesondere eine Schicht auf der Zylinderoberfläche, insbesondere auf der Zylindermantelfläche, zwischen einem inneren und einem äußeren Radius einer Ausdehnung der Gradientenspulenvorrichtung. Ferner ist die, insbesondere zylindrische, Gradientenspulenvorrichtung vorzugsweise um den Untersuchungsbereich der Magnetresonanzanlage herum angeordnet.

Durch die zumindest teilweise Anordnung des zumindest einen Shimspulenelements in der Gradientenspulenschicht zusätzlich zur Gradientenspulenvorrichtung kann eine, den Untersuchungsbereich der Magnetresonanzanlage umgebende, Anordnung der Shimspulenvorrichtung ohne zusätzlichen Raumbedarf erreicht werden. Dabei kann das zumindest eine Shimspulenelement der Shimspulenvorrichtung innerhalb der Gradientenspulenschicht und dabei insbesondere zwischen dem inneren und dem äußeren Radius der, insbesondere zylindrischen, Gradientenspulenschicht angeordnet sein. Dadurch, dass die Shimspulenvorrichtung innerhalb der Gradientenspulenschicht angeordnet ist, und die Gradientenspulenvorrichtung häufig einen tragenden Bestandteil aufweist, kann bei der Shimspulenvorrichtung häufig auf weitere tragende Bestandteile verzichtet werden. Dies ist insbesondere für einen geringeren Raumbedarf und eine leichte Bauweise der Shimspulenvorrichtung vorteilhaft.

In einer weiteren vorteilhaften Ausführungsform können die Shimspulenvorrichtung und die Gradientenspulenvorrichtung dazu ausgebildet sein, von einem gemeinsamen, insbesondere elektrischen, Verstärker gespeist zu werden. Hierbei kann eine Speisung der Gradientenspulenvorrichtung und der Shimspulenvorrichtung durch einen gemeinsamen Verstärker erfolgen. Ferner umfasst die Gradientenspulenvorrichtung vorzugsweise zumindest ein Gradientenspulenelement, wobei das zumindest eine Gradientenspulenelement und das zumindest eine Shimspulenelement, insbesondere gekoppelt, von einem gemeinsamen Verstärker gespeist werden können.

Das zumindest eine Gradientenspulenelement ist beispielsweise eine elektrisch leitfähige Struktur, die derart ausgebildet ist, dass bei einem elektrischen Stromfluss durch die elektrisch leitfähige Struktur, insbesondere bei einer Speisung des Gradientenspulenelements, ein Magnetfeld-Gradient, insbesondere ein räumlich lineares Magnetfeld erzeugt wird. Zur Ausgabe eines Magnetfeld-Gradienten und zum Ausgleich von Grundmagnetfeldinhomogenitäten erster Ordnung kann eine, insbesondere gleichzeitige, Speisung des zumindest einen Gradientenspulenelements und des zumindest einen Shimspulenelements mit jeweils verschiedenen Stromstärken erfolgen. Dies kann beispielsweise durch einen variablen elektrischen Widerstand und/oder eine geeignete elektrische und/oder elektromagnetische Kopplung der jeweiligen Spulenelemente ermöglicht werden. Hierbei kann insbesondere eine induktive Kopplung der Gradientenspulenvorrichtung und der Shimspulenvorrichtung bei einer Anpassung der Speisung mittels des gemeinsamen Verstärkers vorteilhaft berücksichtigt werden.

Ferner kann durch eine geeignete Ausbildung der Shimspulenvorrichtung, insbesondere einer gegenüber zumindest einem Gradientenspulenelement der Gradientenspulenvorrichtung entgegengesetzt gewundenen Anordnung des zumindest einen Shimspulenelements, eine variable Magnetfeldabschirmung bei einer Speisung der Shimspulenvorrichtung und der Gradientenspulenvorrichtung erreicht werden.

In einer weiteren vorteilhaften Ausführungsform können die Shimspulenvorrichtung und die Gradientenspulenvorrichtung dazu ausgebildet sein, von jeweils einem separaten Verstärker gespeist zu werden. Hierbei weisen die jeweiligen Vorrichtungen verschiedene Anforderungen an den jeweiligen Verstärker zur Speisung auf. Während die Shimspulenvorrichtung vorzugsweise von einem Gleichstromverstärker gespeist werden kann, erfordert die Gradientenspulenvorrichtung eine schnell variierende Speisung von dem Verstärker. Durch eine separate Speisung der Shimspulenvorrichtung und der Gradientenspulenvorrichtung durch jeweils einen separaten Verstärker, kann eine jeweils optimierte Speisung erfolgen, wobei die jeweils zur Verfügung stehenden Speisekapazitäten erhalten bleiben. Bei der gleichzeitigen Speisung der Shimspulenvorrichtung und der Gradientenspulenvorrichtung welche beide in der Gradientenspulenschicht angeordnet sind, kann insbesondere eine induktive Kopplung berücksichtigt werden. Zudem kann durch eine geeignete, beispielsweise geometrisch um 45 Grad rotierte, räumliche Anordnung des zumindest einen Shimspulenelements gegenüber einer räumlichen Anordnung des zumindest einen Gradientenspulenelements der Gradientenspulenvorrichtung eine induktive Kopplung verringert werden.

In einer weiteren vorteilhaften Ausführungsform kann das zumindest eine Shimspulenelement als Fingerabdruck-Spule (ein "Fingerprint"-Design aufweisend) ausgebildet sein. Hierdurch wird ein optimiertes, insbesondere an bauliche Vorgaben der Gradientenspulenschicht und/oder der Magnetresonanzanlage und/oder weiterer Komponenten, angepasstes Design des zumindest einen Shimspulenelements ermöglicht. Beispielsweise kann das zumindest eine Shimspulenelement derart ausgebildet sein, dass zumindest eine Öffnung, beispielsweise zur Anordnung eines Fensters und/oder zum Durchlass eines chirurgischen Instrumentes, innerhalb der Shimspulenvorrichtung ermöglicht wird. Ferner kann durch Ausbildung des zumindest einen Shimspulenelements als Fingerabdruck-Spule eine besonders optimierte Anordnung der Shimspulenvorrichtung innerhalb der Gradientenspulenschicht ermöglicht werden.

Des Weiteren kann durch eine optimierte Ausbildung des zumindest einen Spulenelements als Fingerabdruck-Spule unter Kenntnis der Anordnung zumindest eines Gradientenspulenelements der Gradientenspulenvorrichtung eine besonders geringe induktive Kopplung erreicht werden.

In einer weiteren vorteilhaften Ausführungsform kann die Shimspulenvorrichtung mehrere gleiche Shimspulenelemente umfassen. Dabei kann die Shimspulenvorrichtung insbesondere als Matrix-Spule ausgebildet sein. Dadurch dass die Shimspulenvorrichtung mehrere gleiche Shimspulenelemente umfasst, kann eine besonders kostengünstige Herstellung und/oder Wartung ermöglicht werden.

In einer weiteren vorteilhaften Ausführungsform kann die Shimspulenvorrichtung mehrere Shimspulenelemente umfassen, wobei die mehreren Shimspulenelemente dazu ausgebildet sind, über jeweils einen Kanal des die Shimspulenvorrichtung speisenden Verstärkers gespeist zu werden. Hierdurch kann vorteilhafterweise eine gezielte und an den Untersuchungsbereich angepasste Speisung der mehreren Shimspulenelemente ermöglicht werden. Dadurch kann beispielsweise eine besonders schnelle und einfache Anpassung des Ausgleichs der Grundmagnetfeldinhomogenitäten erster Ordnung bei einer geänderten Lage des Untersuchungsobjektes und/oder eine Bewegung eines, insbesondere ferromagnetischen, Objektes innerhalb des Untersuchungsbereiches erfolgen. Insbesondere kann bei der Speisung der mehreren Shimspulenelemente über jeweils einen Kanal des die Shimspulenvorrichtung speisenden Verstärkers eine induktive Kopplung der mehreren Shimspulenelemente berücksichtigt werden.

In einer weiteren vorteilhaften Ausführungsform können die mehreren Shimspulenelemente n-fach rotationssymmetrisch um eine Längsachse des Untersuchungsbereiches der Magnetresonanzanlage herum angeordnet sein, wobei n eine natürliche Zahl größer 1 ist. Hierdurch kann eine besonders kostengünstige, insbesondere modulare, Bauweise der Shimspulenvorrichtung ermöglicht werden. Ferner kann durch eine n-fach rotationssymmetrische Ausbildung der Shimspulenvorrichtung ein besonders einfacher und schneller Ausgleich von Grundmagnetfeldinhomogenitäten erster Ordnung erfolgen, welche beispielsweise durch eine Rotationsbewegung eines, insbesondere ferromagnetischen, Objektes um eine Längsachse des Untersuchungsbereiches herum, entstehen.

Des Weiteren kann die Shimspulenvorrichtung in einer modularen Bauweise entlang eines Umfangs und/oder einer Längsrichtung des Untersuchungsbereiches geteilt ausgebildet sein. Durch die geteilte und n-fach rotationssymmetrische Ausführungsform kann eine kostengünstige Herstellung und Wartung ermöglicht werden.

In einer weiteren vorteilhaften Ausführungsform kann jedes der mehreren Shimspulenelemente dazu ausgebildet sein, jeweils einen Term einer Kugelflächenzerlegung der Grundmagnetfeldinhomogenitäten erster Ordnung auszugleichen. Hierdurch kann vorteilhafterweise eine gezielte Speisung der einzelnen Shimspulenelemente mittels des die Shimspulenvorrichtung speisenden Verstärkers erfolgen. Ferner kann eine induktive Kopplung einzelner Shimspulenelemente untereinander und/oder zwischen den mehreren Shimspulenelemente und Gradientenspulenelementen der Gradientenspulenvorrichtung besser reduziert werden, da eine voneinander getrennte, insbesondere unterschiedliche, Speisung der einzelnen Shimspulenelemente erfolgen kann. Zudem kann eine Zuordnung der mehreren Shimspulenelemente zu den jeweils auszugleichenden Termen der Kugelflächenzerlegung der Grundmagnetfeldinhomogenitäten erster Ordnung bei der geometrischen Anordnung der Shimspulenelemente in der Gradientenspulenschicht vorteilhaft berücksichtigt werden.

In einer weiteren vorteilhaften Ausführungsform können jeweils mehrere zusammenwirkende Shimspulenelemente dazu ausgebildet sein, jeweils zumindest anteilig mehrere Terme einer Kugelflächenzerlegung der Grundmagnetfeldzerlegung erster Ordnung auszugleichen. Dies kann insbesondere bei einer Ausbildung der Shimspulenvorrichtung als Matrix-Spule vorteilhaft sein. Hierbei kann ein geeignetes Shimprofil des der die Shimspulenvorrichtung speisenden Verstärkers zum Ausgleich der Grundmagnetfeldinhomogenitäten erster Ordnung, insbesondere dynamisch, gewählt werden.

Das Shimprofil kann insbesondere eine Zuordnung und/oder eine räumliche Abbildung zumindest eines Teils eines das Grundmagnetfeld homogenisierenden Magnetfeldes zu den mehreren Shimspulenelementen umfassen. Hierbei kann das Shimprofil vorzugsweise eine Zuordnung von Skalierungsfaktoren zu jedem der mehren Shimspulenelemente umfassen, wobei die Skalierungsfaktoren basierend auf der Grundmagnetfeldstärke eine Feldstärke des das Grundmagnetfeld homogenisierenden Magnetfeldes vorgeben können.

Ferner kann bei einer n-fach rotationssymmetrischen Anordnung der mehreren zusammenwirkenden Shimspulenelemente eine besonders intuitive und schnelle dynamische Anpassung eines Shimprofils an eine geänderte Position eines um eine Längsachse des Untersuchungsbereiches rotationsbewegten, insbesondere ferromagnetischen, Objektes ermöglicht werden.

Durch eine höhere Anzahl an Shimspulenelementen kann eine genauere, insbesondere maßgeschneiderte, Anordnung der Shimspulenelemente innerhalb der Gradientenspulenschicht erfolgen. Dabei können weitere Komponenten und/oder Bauteile der Magnetresonanzanlage bei der Anordnung der mehreren Shimspulenelemente berücksichtigt werden.

In einer weiteren vorteilhaften Ausführungsform kann die Shimspulenvorrichtung mehrere Speisepunkte umfassen, die jeweils mit einem der mehreren Shimspulenelemente elektrisch verbunden sind. Dabei können die mehreren Speisepunkte entlang eines Umfangs innerhalb der Gradientenspulenschicht angeordnet sein. Zudem kann die Magnetresonanzanlage mehrere Kontaktflächen umfassen, die jeweils mit einem der mehreren Kanäle des Verstärkers elektrisch verbunden sind. Ferner sind die mehreren Kontaktflächen vorzugsweise entlang des Umfangs innerhalb der Gradientenspulenschicht angeordnet. Hierbei kann jeder Speisepunkt jeweils eine Kontaktfläche elektrisch kontaktieren. Des Weiteren kann die Shimspulenvorrichtung dazu ausgebildet sein, Grundmagnetfeldinhomogenitäten erster Ordnung auszugleichen, welche durch eine Rotationsbewegung eines starr mit der Anordnung von Kontaktflächen verbundenen, insbesondere ferromagnetischen, Objekts relativ zur Shimspulenvorrichtung um eine Längsachse des Untersuchungsbereiches der Magnetresonanzanlage herum, entsteht.

Aus dem Stand der Technik ist bekannt, dass häufig zur Bestimmung eines Shimprofils und/oder Speiseprofils zum Ausgleich der Grundmagnetfeldinhomogenitäten eine Magnetfeldkarte aufgenommen wird. Diese Magnetfeldkarte umfasst dabei eine räumliche Abbildung der Grundmagnetfeldstärke und/oder der Grundmagnetfeldinhomogenitäten.

Das Speiseprofil kann vorteilhafterweise eine Zuordnung von Stromstärken für eine elektrische Speisung und/oder von Skalierungsfaktoren für eine elektrische Speisung mit einer, insbesondere zeitlich konstanten, Grundstromstärke zu jeweils einem der mehreren Shimspulenelemente umfassen.

Bei der hier vorgeschlagenen Ausführungsform kann ein erstes Shimprofil und/oder Speiseprofil für den die Shimspulenvorrichtung speisenden Verstärker zum Ausgleich der Grundmagnetfeldinhomogenitäten erster Ordnung für eine statische Anordnung des Objektes und der Magnetresonanzanlage ermittelt und/oder ausgegeben werden.

Bei der Rotationsbewegung des starr mit der Anordnung von Kontaktflächen verbundenen Objektes relativ zur Shimspulenvorrichtung um die Längsachse des Untersuchungsbereiches herum kommt es insbesondere zu einer geänderten Kontaktierung der Speisepunkte entlang des Umfangs der Shimspulenvorrichtung. Da jeder der Speisepunkte elektrisch mit jeweils einem der mehreren Shimspulenelemente verbunden ist, kommt es hierbei vorzugsweise zu einer geänderten Zuordnung zwischen den mehreren Kanälen des Verstärkers und den von jedem der Kanäle gespeisten Shimspulenelementen. Durch die mechanisch geänderte Kontaktierung zwischen den mehreren Speisepunkten und den mehreren Kontaktflächen entlang eines Umfangs kann eine besonders direkte und einfache Anpassung des Shimprofils und/oder Speiseprofils zum Ausgleich der Grundmagnetfeldinhomogenitäten erster Ordnung ermöglicht werden.

Insbesondere kann durch die mechanische Anpassung des Shimprofils und/oder Speiseprofils auf die Aufnahme von weiteren Magnetfeldkarten verzichtet werden. Hierdurch kann die Messdauer bei einer dynamischen Anpassung des Shimprofils und/oder Speiseprofils an die durch die Rotationsbewegung des Objekts geänderten Grundmagnetfeldinhomogenitäten erster Ordnung deutlich reduziert werden.

Zudem erfolgt bei einer geänderten Kontaktierung zwischen den Speisepunkten und Kontaktflächen eine Rotation des ersten Shimprofils und/oder Speiseprofils um die Längsachse des Untersuchungsbereiches herum. In Abhängigkeit der Anzahl von, insbesondere gleichmäßig, entlang des Umfangs innerhalb der Gradientenspulenschicht angeordneten Speisepunkte und Kontaktflächen kann eine bestimmte Anzahl von Rotationswinkeln rein mechanisch ausgeglichen werden. Hierbei kann insbesondere eine Ausbildung der Shimspulenvorrichtung mit mehreren Shimspulenelementen, welche n-fach rotationssymmetrisch um die Längsachse des Untersuchungsbereichs herum angeordnet sind, vorteilhaft sein. Ferner können auch mehrere Shimspulenelemente aus der Menge aller Shimspulenelemente der Shimspulenvorrichtung jeweils zusammen von einem Kanal des Verstärkers gespeist werden.

Insbesondere bei einer Rotationsbewegung des Objekts zu Rotationswinkeln welche zwischen den Rotationswinkeln der n-fachen Rotationssymmetrie der Shimspulenvorrichtung liegen, kann ein Ausgleich der geänderten, insbesondere um die Längsachse herum rotierten, Grundmagnetfeldinhomogenitäten erster Ordnung über eine elektronische Anpassung des ersten Shimprofils und/oder Speiseprofils erfolgen.

In einer weiteren vorteilhaften Ausführungsform kann die Shimspulenvorrichtung zumindest einen Bewegungssensor umfassen, der dazu ausgebildet ist, eine Bewegung eines, insbesondere ferromagnetischen, Objektes relativ zur Shimspulenvorrichtung zu erfassen. Dabei kann die Shimspulenvorrichtung dazu ausgebildet sein, mittels der durch den zumindest einen Bewegungssensor erfassten Bewegung einen Ausgleich der Grundmagnetfeldinhomogenitäten durchzuführen.

Der Bewegungssensor kann dabei insbesondere einen optischen und/oder elektromagnetischen und/oder mechanischen Sensor umfassen. Das Objekt, dessen Bewegung durch den Bewegungssensor erfasst wird, kann beispielsweise eine Komponente der Magnetresonanzanlage und/oder ein an einem Untersuchungsobjekt angeordnetes Objekt und/oder ein chirurgisches Instrument und/oder ein bewegliches Röntgengerät umfassen.

Der Bewegungssensor erzeugt bei der Erfassung einer Bewegung des Objektes relativ zur Shimspulenvorrichtung vorzugsweise ein Signal, welches zum Ausgleich der Grundmagnetfeldinhomogenitäten genutzt werden kann. Vorteilhafterweise kann ein erstes Shimprofil und/oder Speiseprofil für den die Shimspulenvorrichtung speisenden Verstärker zum Ausgleich der Grundmagnetfeldinhomogenitäten erster Ordnung für eine statische Anordnung des Objektes und der Magnetresonanzanlage ermittelt und/oder ausgegeben werden. Mittels des von dem Bewegungssensor gebildeten Signals kann anschließend eine besonders schnelle und einfache Anpassung des Shimprofils und/oder Speiseprofils zum Ausgleich der durch die Bewegung des Objekts geänderten Grundmagnetfeldinhomogenitäten erster Ordnung erfolgen. Durch die Verwendung des Bewegungssensors zur Erfassung einer Bewegung des Objekts relativ zur Shimspulenvorrichtung kann eine Anpassung des Shimprofils und/oder Speiseprofils ohne zusätzliche Aufnahme einer Magnetfeldkarte ermöglicht werden. Hierdurch kann eine deutlich geringere Messdauer erreicht werden.

Nachstehend werden Verfahren zum Ausgleich von Grundmagnetfeldinhomogenitäten erster Ordnung in einem Untersuchungsbereich einer Magnetresonanzanlage beschrieben. Die Vorteile dieser Verfahren entsprechen im Wesentlichen den Vorteilen der vorab beschriebenen beispielhaften Magnetresonanzanlagen zum Ausgleich von Grundmagnetfeldinhomogenitäten erster Ordnung in einem Untersuchungsbereich der Magnetresonanzanlage. Hierbei erwähnte Merkmale, Vorteile oder alternative Ausführungsformen können ebenso auch auf die anderen beanspruchten Gegenstände übertragen werden und umgekehrt.

In einem erfindungsgemäßen Verfahren umfasst die Magnetresonanzanlage eine Shimspulenvorrichtung und eine Gradientenspulenvorrichtung, wobei die Shimspulenvorrichtung zumindest ein Shimspulenelement umfasst. Ferner ist die Gradientenspulenvorrichtung in einer Gradientenspulenschicht angeordnet, wobei das zumindest eine Shimspulenelement zusätzlich zur Gradientenspulenvorrichtung in der Gradientenspulenschicht angeordnet ist. Dabei werden die Grundmagnetfeldinhomogenitäten erster Ordnung durch eine Speisung der Shimspulenvorrichtung ausgeglichen.

In einer weiteren vorteilhaften Ausführungsform eines erfindungsgemäßen Verfahrens können die Shimspulenvorrichtung und die Gradientenspulenvorrichtung von einem gemeinsamen Verstärker gespeist werden.

Des Weiteren können die Shimspulenvorrichtung und die Gradientenspulenvorrichtung von jeweils einem separaten Verstärker gespeist werden.

In einer weiteren vorteilhaften Ausführungsform kann die Shimspulenvorrichtung mehrere Shimspulenelemente umfassen, wobei die mehreren Shimspulenelemente über jeweils einen Kanal des die Shimspulenvorrichtung speisenden Verstärkers gespeist werden.

In einer weiteren vorteilhaften Ausführungsform kann mittels jedes der mehreren Shimspulenelemente jeweils ein Term einer Kugelflächenzerlegung der Grundmagnetfeldinhomogenitäten erster Ordnung ausgeglichen werden.

In einer weiteren vorteilhaften Ausführungsform können mittels jeweils mehreren zusammenwirkenden Spulenelementen jeweils zumindest anteilig mehrere Terme einer Kugelflächenzerlegung der Grundmagnetfeldinhomogenitäten erster Ordnung ausgeglichen werden.

In einer weiteren vorteilhaften Ausführungsform umfasst die Shimspulenvorrichtung mehrere Speisepunkte, die jeweils mit einem der mehreren Shimspulenelemente elektrisch verbunden sind. Dabei können die mehreren Speisepunkte entlang eines Umfangs innerhalb der Gradientenspulenschicht angeordnet sein. Ferner kann die Magnetresonanzanlage mehrere Kontaktflächen umfassen, die jeweils mit einem der mehreren Kanäle des Verstärkers elektrisch verbunden sind. Hierbei können die mehreren Kontaktflächen vorzugsweise entlang des Umfangs innerhalb der Gradientenspulenschicht angeordnet sein. Zudem kontaktiert jeder Speisepunkt idealerweise jeweils eine Kontaktfläche elektrisch. Dabei kann die Grundmagnetfeldinhomogenitäten erster Ordnung, welche mittels einer Rotationsbewegung eines starr mit der Anordnung von Kontaktflächen verbundenen, insbesondere ferromagnetischen, Objekts relativ zur Shimspulenvorrichtung um eine Längsachse des Untersuchungsbereiches der Magnetresonanzanlage herum, entsteht, kann durch die Shimspulenvorrichtung ausgeglichen werden.

In einer weiteren vorteilhaften Ausführungsform kann die Shimspulenvorrichtung zumindest einen Bewegungssensor umfassen. Hierbei kann mittels des Bewegungssensors eine Bewegung eines, insbesondere ferromagnetischen, Objektes relativ zur Shimspulenvorrichtung erfasst werden. Des Weiteren kann mittels der Shimspulenvorrichtung und der durch den zumindest einen Bewegungssensor erfassten Bewegung ein Ausgleich der Grundmagnetfeldinhomogenitäten durchgeführt werden.

Ferner kann die Magnetresonanzanlage eine Darstellungseinheit, beispielsweise ein Display und/oder Monitor und/oder eine LED-Anzeige, umfassen, welche dazu ausgebildet ist, Informationen und/oder graphische Darstellungen von Informationen der Magnetresonanzanlage und/oder von weiteren Komponenten der Magnetresonanzanlage anzuzeigen.

Ferner wird ein Computerprogrammprodukt vorgeschlagen, das ein Programm umfasst und direkt in einen Speicher einer programmierbaren Recheneinheit ladbar ist und Programmmittel, z.B. Bibliotheken und Hilfsfunktionen, aufweist, um ein Verfahren zum Ausgleich von Grundmagnetfeldinhomogenitäten erster Ordnung in einem Untersuchungsbereich einer Magnetresonanzanlage auszuführen, wenn das Computerprogrammprodukt ausgeführt wird. Das Computerprogrammprodukt kann dabei eine Software mit einem Quellcode, der noch kompiliert und gebunden oder der nur interpretiert werden muss, oder einen ausführbaren Softwarecode umfassen, der zur Ausführung nur noch in die Verarbeitungseinheit zu laden ist. Durch das Computerprogrammprodukt kann das ein Verfahren zum Ausgleich von Grundmagnetfeldinhomogenitäten erster Ordnung in einem Untersuchungsbereich einer Magnetresonanzanlage schnell, identisch wiederholbar und robust ausgeführt werden. Das Computerprogrammprodukt ist so konfiguriert, dass es mittels der Verarbeitungseinheit die erfindungsgemäßen Verfahrensschritte ausführen kann. Die Verarbeitungseinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer Verarbeitungseinheit geladen werden kann, der mit der Verarbeitungseinheit direkt verbunden oder als Teil der Verarbeitungseinheit ausgebildet sein kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Verarbeitungseinheit ein erfindungsgemäßes Verfahren durchführen. Beispiele für elektronisch lesbare Datenträger sind eine DVD, ein Magnetband oder ein USB-Stick, auf welchem elektronisch lesbare Steuerinformationen, insbesondere Software, gespeichert ist. Wenn diese Steuerinformationen von dem Datenträger gelesen und in eine Verarbeitungseinheit gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Ausführungsbeispiele der Erfindung sind in den Zeichnungen dargestellt und werden im Folgenden näher beschrieben. In unterschiedlichen Figuren werden für gleiche Merkmale die gleichen Bezugszeichen verwendet. Es zeigen

Fig. 1     eine schematische Darstellung einer Magnetresonanzanlage, welche eine Shimspulenvorrichtung und eine Gradientenspulenvorrichtung umfasst, die von einem gemeinsamen Verstärker gespeist werden;

Fig. 2     eine schematische Darstellung einer Magnetresonanzanlage, welche eine Shimspulenvorrichtung und eine Gradientenspulenvorrichtung umfasst, die von jeweils einem separaten Verstärker gespeist werden;

Fig. 3     eine schematische Darstellung einer Ausbildung der Shimspulenvorrichtung als Fingerabdruckspule mit mehreren Shimspulenelementen;

Fig. 4     eine schematische Darstellung einer Ausbildung der Shimspulenvorrichtung mit mehreren gleichen Shimspulenelementen;

Fig. 5     eine schematische Darstellung einer n-fach rotationssymmetrischen Ausbildung der Shimspulenvorrichtung;

Fig. 6     eine schematische Darstellung einer Magnetresonanzanlage, welche eine n-fach rotationssymmetrisch ausgebildete Shimspulenvorrichtung mit mehreren Speisepunkten und Kontaktflächen umfasst;

Fig. 7     eine schematische Darstellung einer Magnetresonanzanlage, welche eine Shimspulenvorrichtung mit einem Bewegungssensor umfasst.

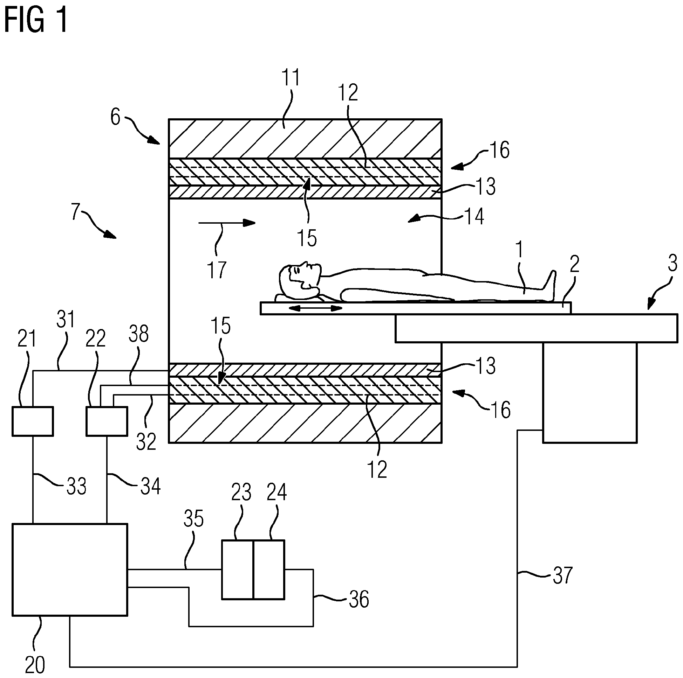

In Fig. 1 ist eine Variante einer erfindungsgemäßen Magnetresonanzanlage 7 zur Durchführung eines vorgeschlagenen Verfahrens schematisch dargestellt. Dabei umfasst die Magnetresonanzanlage 7 eine Magneteinheit 6 und einen Untersuchungsbereich 14. Die Magneteinheit 6 umfasst hier ferner einen supraleitenden Grundmagneten 11, welcher ausgebildet ist, ein starkes Grundmagnetfeld 17 mit einer zeitlich konstanten Grundmagnetfeldstärke zu erzeugen. Insbesondere kann der Untersuchungsbereich 14 eine Zylinderform aufweisen, wobei der Untersuchungsbereich 14 von der Magneteinheit 6 entlang einer Mantelfläche des Zylinders umschlossen werden kann. Dabei weist der Untersuchungsbereich 14 zumindest eine Öffnung zur Aufnahme eines Untersuchungsobjektes 1 und einer Lagerungseinrichtung 2 auf. Die Lagerungseinrichtung 2 ist beweglich gelagert, sodass eine Positionierung des Untersuchungsobjektes 1 von einer Position außerhalb der Magnetresonanzanlage 7 in den Untersuchungsbereich 14 hinein erfolgen kann. Hierbei kann die Lagerungseinrichtung 2 von einem Lagerungstisch 3 gestützt und, insbesondere motorisiert und/oder automatisch, bewegt werden. Hierfür kann eine Verarbeitungseinheit 20 ein Signal 37 an den Lagerungstisch 3 senden. Umgekehrt, kann eine Abfrage der aktuellen Positionierung des Untersuchungsobjektes 1 über die Abfrage eines Signals 37 durch die Verarbeitungseinheit 20 vom Lagerungstisch 3 erfolgen.

Des Weiteren umfasst die Magneteinheit 6 eine Gradientenspulenvorrichtung 12, die dazu ausgebildet ist, Magnetfeld-Gradienten, insbesondere Lesegradienten, zur Ortskodierung bei einer Bildaufnahme zu erzeugen. Eine Steuerung der Gradientenspulenvorrichtung 12 kann mittels eines Verstärkers 22 erfolgen. Hierfür kann der Verstärker 22 einen variablen Strom 32 in die Gradientenspulenvorrichtung 12 einspeisen. Hierbei ist die Gradientenspulenvorrichtung 12 innerhalb einer Gradientenspulenschicht 16 angeordnet. Des Weiteren umfasst die Magneteinheit 6 eine Shimspulenvorrichtung 15, die dazu ausgebildet ist, Grundmagnetfeldinhomogenitäten erster Ordnung in dem Untersuchungsbereich 14 der Magnetresonanzanlage 7 auszugleichen. Hierbei umfasst die Shimspulenvorrichtung 15 zumindest ein Shimspulenelement (hier nicht gezeigt), wobei zumindest ein Teil des zumindest einen Shimspulenelements zusätzlich zur Gradientenspulenvorrichtung 12 in der Gradientenspulenschicht 16 angeordnet ist.

In Fig. 1 ist eine Ausführungsform einer erfindungsgemäßen Variante einer Magnetresonanzanlage dargestellt, wobei die Gradientenspulenvorrichtung 12 und die Shimspulenvorrichtung 15 ausgebildet sind, von einem gemeinsamen Verstärker 22, insbesondere mittels eines jeweils variablen und/oder konstanten Stroms 32 und 38, gespeist zu werden.

Die Magneteinheit 6 weist zudem eine HF-Antenneneinheit 13 auf, welche im vorgeschlagenen Ausführungsbeispiel als Körperspule ausgebildet ist. Dabei ist die HF-Antenneneinheit 13 fest in die Magneteinheit 6 integriert und umgibt den Untersuchungsbereich 14. Die HF-Antenneneinheit 13 ist dazu ausgebildet, eine Magnetisierung auszulenken. Die Magnetisierung kommt als eine Netto-Magnetisierung zustande, wobei es in einem Gleichgewichtszustand zu einer parallelen Ausrichtung von Protonenspins im Grundmagnetfeld 17 kommt. Insbesondere kann eine Anregung der Polarisation durch Ausgabe von Anregungspulsen und/oder Refokussierungspulsen erfolgen. Ferner kann die HF-Antenneneinheit 13 durch ein Signal 31 von einer HF-Verarbeitungseinheit 21 gesteuert werden.

Die HF-Antenneneinheit 13 ist ferner dazu ausgebildet, MR-Signale zu empfangen. Hierbei kann die HF-Antenneneinheit ein entsprechendes Signal 31 an die HF-Verarbeitungseinheit 21 senden.

Die Steuerung des Verstärkers 22, der HF-Verarbeitungseinheit 21 und des Grundmagneten 6 kann insbesondere über eine Verarbeitungseinheit 20 der Magnetresonanzanlage 7 erfolgen. Hierfür können beispielsweise die Signale 33 und 34 bidirektional genutzt werden.

Die Verarbeitungseinheit 20 kann dazu ausgebildet sein, eine Sequenz, beispielsweise zur Erzeugung von MR-Bildern, in Signale für die jeweiligen Komponenten der Magnetresonanzanlage 7 zu übersetzen. Hierdurch kann das Durchführen einer Sequenz bei einer MR-Untersuchung ermöglicht werden. Ferner kann die Verarbeitungseinheit 20 dazu ausgebildet sein, die von der HF-Antenneneinheit 13 empfangenen MR-Signale zu verarbeiten und beispielsweise daraus MR-Bilder zu erzeugen.

Des Weiteren umfasst die vorgeschlagene Magnetresonanzanlage 7 eine Darstellungseinheit 23, welche ausgebildet ist, Parameterwerte einer Sequenz und/oder MR-Bilder darzustellen. Hierfür kann die Verarbeitungseinheit 20 ein Signal 35 an die Darstellungseinheit 23 senden. Die Darstellungseinheit 23 kann dabei als Monitor und/oder Display ausgebildet sein. Ferner kann die Magnetresonanzanlage 7 eine Eingabeeinheit 24, beispielsweise eine Tastatur und/oder ein Touchscreen und/oder eine Knopfanordnung, umfassen, die dazu ausgebildet ist, eine Eingabe eines Bedienpersonals durch ein Signal 36 an die Verarbeitungseinheit 20 zu senden.

Eine Steuerung der Lagerungseinrichtung 2 kann ebenfalls über eine Eingabe eines Bedienpersonals an der Eingabeeinheit 24 ermöglicht werden. Hierbei kann die Verarbeitungseinheit 20 ein Signal 37 an den Lagerungstisch 3 senden, wodurch eine automatische und/oder halb-automatische Positionierung des Untersuchungsobjektes 1 relativ zu einem Iso-Zentrum der Magnetresonanzanlage 7 ermöglicht wird.

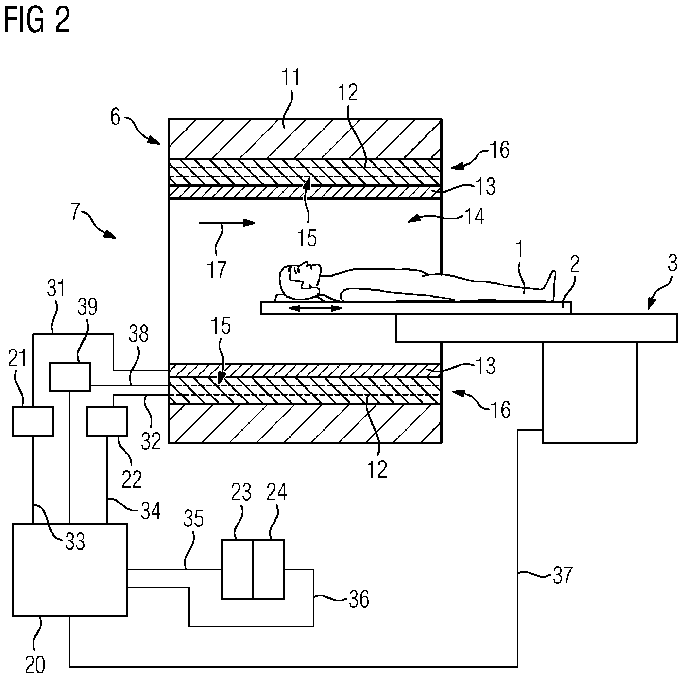

In der in Fig. 2 dargestellten Ausführungsform einer vorgeschlagenen Magnetresonanzanlage sind die Shimspulenvorrichtung 15 und die Gradientenspulenvorrichtung 12 dazu ausgebildet, von jeweils einem separaten Verstärker 22 und 39 gespeist zu werden. Hierbei kann der Verstärker 39, der die Shimspulenvorrichtung 15 speist, insbesondere einen zeitlich konstanten Strom 38 einspeisen.

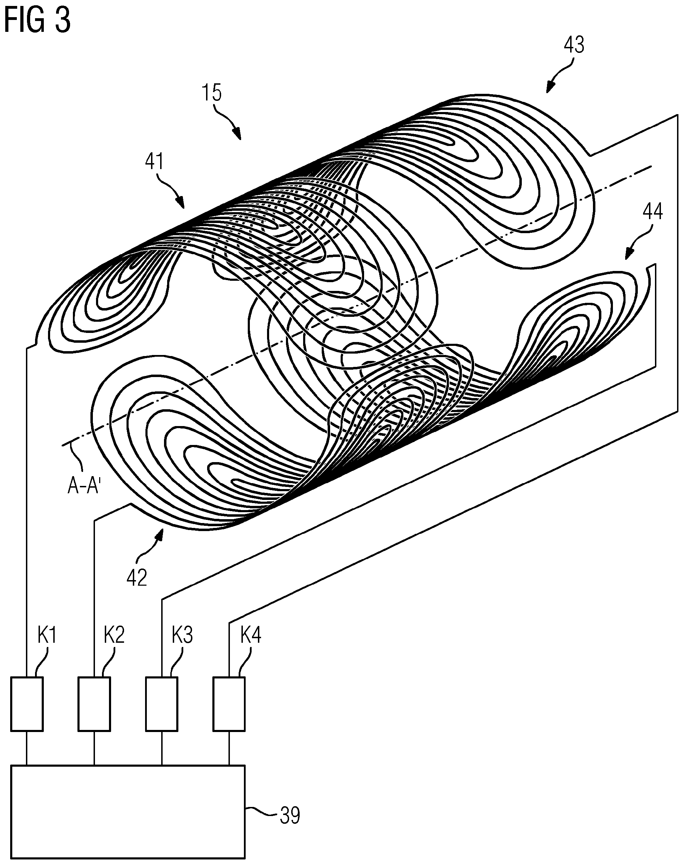

In Fig. 3 ist eine schematische Darstellung einer Ausbildung der Shimspulenvorrichtung 15 als Fingerabdruck-Spule dargestellt. Hierbei kann die Shimspulenvorrichtung 15 beispielsweise vier Shimspulenelemente 41 bis 44 umfassen, welche jeweils über einen von mehreren Kanälen K1 bis K4 des Verstärkers 39 gespeist werden. Vorzugsweise sind die Shimspulenelemente 41 bis 44 innerhalb einer zylindrischen Gradientenspulenschicht 16 um eine Längsachse A-A' des Untersuchungsbereichs 14 herum angeordnet. Hierbei kann insbesondere eine überlappende und/oder räumlich getrennte Anordnung der mehreren Shimspulenelemente vorteilhaft sein. In Fig. 3 weist jedes der vier Shimspulenelemente 41 bis 44 jeweils ein charakteristisches Wicklungsmuster auf, welches optisch als Fingerabdruck beschrieben werden kann. Hierdurch kann eine besonders geeignete und/oder maßgeschneiderte Anpassung der mehreren Shimspulenelemente 41 bis 44 an eine, insbesondere statische, Anordnung von Komponenten der Magnetresonanzanlage 7 und/oder weiterer Objekte erfolgen.

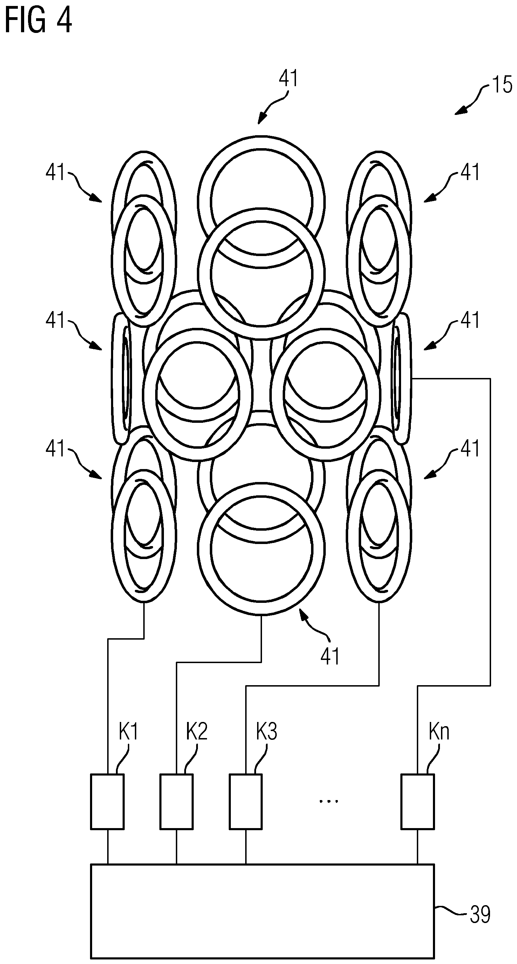

In Fig. 4 ist eine schematische Darstellung einer Ausbildung der Shimspulenvorrichtung 15 mit mehreren gleichen Shimspulenelementen 41 abgebildet. Dabei können die mehreren, insbesondere n, Shimspulenelemente 41 vorteilhafterweise dazu ausgebildet sein, über jeweils einen Kanal K1 bis Kn des Verstärkers 39 gespeist zu werden, wobei n eine natürliche Zahl größer 1 ist. Hierdurch wird eine besonders genaue und dynamische Anpassung eines Shimprofils und/oder Speiseprofils des Verstärkers 39 ermöglicht, beispielsweise an ein räumlich ausgedehntes Untersuchungsobjekt 1.

Ferner kann jedes der mehreren Shimspulenelemente 41 dazu ausgebildet sein, jeweils einen Term einer Kugelflächenzerlegung der Grundmagnetfeldinhomogenitäten erster Ordnung auszugleichen. Hierbei kann zu jedem Term der Kugelflächenzerlegung der Grundmagnetfeldinhomogenitäten erster Ordnung jeweils eine besonders geeignete geometrische Anordnung der zugeordneten Shimspulenelemente 41 erfolgen. Beispielsweise kann die geometrische Anordnung der mehreren Shimspulenelemente 41 in Abhängigkeit der Anordnung von Gradientenspulenelementen der Gradientenspulenvorrichtung 12 erfolgen. Hierdurch kann eine induktive Kopplung verringert werden.

In einer weiteren vorteilhaften Ausführungsform können jeweils mehrere zusammenwirkende Shimspulenelemente 41 dazu ausgebildet sein, jeweils zumindest anteilig mehrere Terme einer Kugelflächenzerlegung der Grundmagnetfeldinhomogenitäten erster Ordnung auszugleichen. Hierfür kann der Verstärker ein an die Kugelflächenzerlegung der Grundmagnetfeldinhomogenitäten erster Ordnung angepasstes Shimprofil und/oder Speiseprofil über die mehreren Kanäle K1 bis Kn an die mehreren Shimspulenelemente 41 ausgeben.

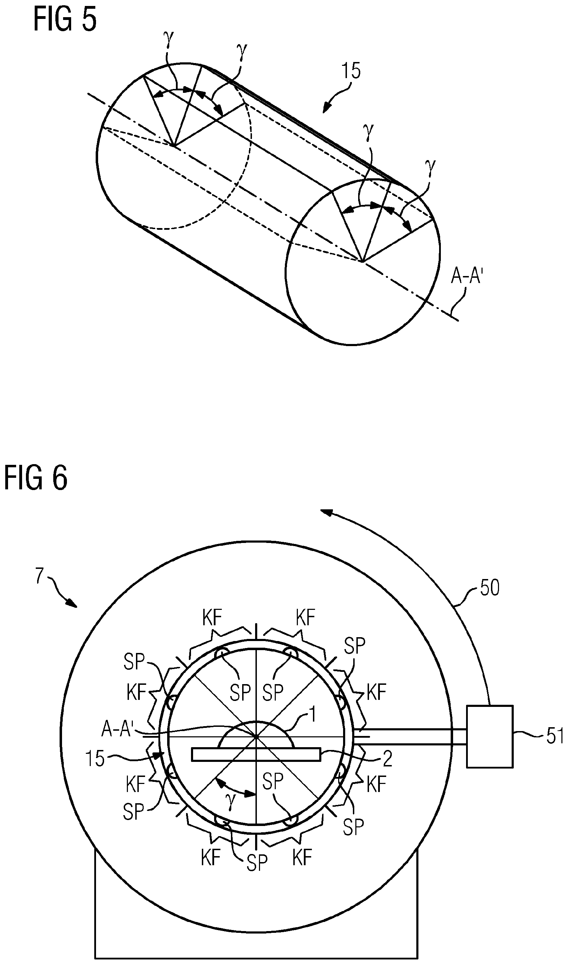

In Fig. 5 ist eine schematische Darstellung einer n-fach rotationssymmetrischen Ausbildung der Shimspulenvorrichtung 15 abgebildet, wobei n eine natürliche Zahl größer 1 ist. Dabei kann die Shimspulenvorrichtung 15 mehrere Shimspulenelemente umfassen, welche insbesondere entlang räumlicher Abschnitte auf einer Zylinderoberfläche innerhalb der Gradientenspulenschicht angeordnet sind. Dabei sind die mehreren Anordnungen von Shimspulenelementen entlang der räumlichen Abschnitte insbesondere n-fach rotationssymmetrisch um die Längsachse A-A' des Untersuchungsbereichs 14 herum. Dabei kann durch eine Aufteilung des Zylinders um den Untersuchungsbereich 14 herum, insbesondere in mehrere jeweils gleich große Zylinderabschnitte mit Rotationswinkel $\gamma$, die n-fache Rotationssymmetrie der mehreren Shimspulenelemente 41 erreicht werden. Hierdurch kann vorteilhafterweise eine besonders kostengünstige modulare Bauweise der Shimspulenvorrichtung 15 ermöglicht werden.

Fig. 6 zeigt eine schematische Darstellung einer Magnetresonanzanlage 7, welche eine n-fach rotationssymmetrisch ausgebildete Shimspulenvorrichtung 15 mit mehreren Speisepunkten SP und Kontaktflächen KF umfasst. Ferner umfasst die Shimspulenvorrichtung 15 in der vorgeschlagenen Ausführungsform mehrere Shimspulenelemente (hier nicht gezeigt), wobei jeder der mehreren Speisepunkte SP jeweils mit einem der mehreren Shimspulenelemente elektrisch verbunden ist. Vorzugsweise sind die mehreren Speisepunkte SP entlang eines Umfangs, insbesondere eines Zylinders um die Längsachse A-A' des Untersuchungsbereichs 14 herum, innerhalb der Gradientenspulenschicht 16 angeordnet. Zudem kann die Magnetresonanzanlage 7 mehrere Kontaktflächen KF umfassen, die jeweils mit einem der mehreren Kanäle des Verstärkers 39 elektrisch verbunden sind.

Im dargestellten Ausführungsbeispiel ist eine 6-fach rotationssymmetrische Anordnung von Shimspulenelementen der Shimspulenvorrichtung 15 abgebildet. Dabei kann jeder der mehreren Speisepunkte SP jeweils einem räumlichen Abschnitt der Gradientenspulenschicht 16 zugeordnet sein. Im vorliegenden Ausführungsbeispiel ist jeweils ein Speisepunkt SP, insbesondere mittig, auf einem Abschnitt einer Zylinderoberfläche eines Rotationswinkels $\gamma$ angeordnet. Ferner kann jeder Speisepunkt SP jeweils eine Kontaktfläche KF elektrisch kontaktieren. Damit eine eindeutige Zuordnung und Kontaktierung zwischen den mehreren Kontaktflächen KF und Speisepunkten SP sichergestellt werden kann, ist eine Anordnung der Kontaktflächen KF entlang eines Umfangs vorteilhaft, welcher insbesondere in mehrere räumliche Abschnitte mittels des Rotationswinkels $\gamma$ unterteilt ist.

Des Weiteren kann die Shimspulenvorrichtung 15 dazu ausgebildet sein, Grundmagnetfeldinhomogenitäten erster Ordnung auszugleichen, welche durch eine Rotationsbewegung 50 eines, insbesondere ferromagnetischen Objekts 51 relativ zur Shimspulenvorrichtung 15, um eine Längsachse A-A' des Untersuchungsbereiches 14 der Magnetresonanzanlage 7 herum, entsteht. Bei einer Rotationsbewegung 50 des Objekts 51 kann eine geänderte elektrische Kontaktierung und Zuordnung zwischen den mehreren Kontaktflächen KF und Speisepunkten SP zustande kommen. Hierdurch kann ein, für eine statische Anordnung des Objekts 51, ermitteltes erstes Shimprofil und/oder Speiseprofil durch die mechanische Rotation der Anordnung von Kontaktflächen KF, welche starr mit dem Objekt 51 verbunden ist, mechanisch angepasst werden. Das erste Shimprofil und/oder Speiseprofil kann beispielsweise durch eine Aufnahme einer Magnetfeldkarte zur Bestimmung der Grundmagnetfeldinhomogenitäten erster Ordnung der statischen Anordnung ermittelt werden.

Die Genauigkeit der mechanischen Anpassung ist dabei abhängig vom Rotationswinkel der Rotationsbewegung 50 und von der Anzahl der Kontaktflächen KF und Speisepunkte SP entlang des Umfangs innerhalb der Gradientenspulenschicht 16. Hierdurch kann vorteilhafterweise auf die Aufnahme einer Magnetfeldkarte zur Bestimmung der durch die Rotationsbewegung 50 des Objekts 51 geänderten Grundmagnetfeldinhomogenitäten erster Ordnung verzichtet werden. Insbesondere in Zwischenbereichen der Rotationsbewegung 50, welche innerhalb eines Rotationswinkels $\gamma$ liegen, kann der Ausgleich der geänderten Grundmagnetfeldinhomogenitäten erster Ordnung durch eine geringe Anpassung des Shimprofils und/oder des Speiseprofils mittels des Verstärkers 39 erfolgen.

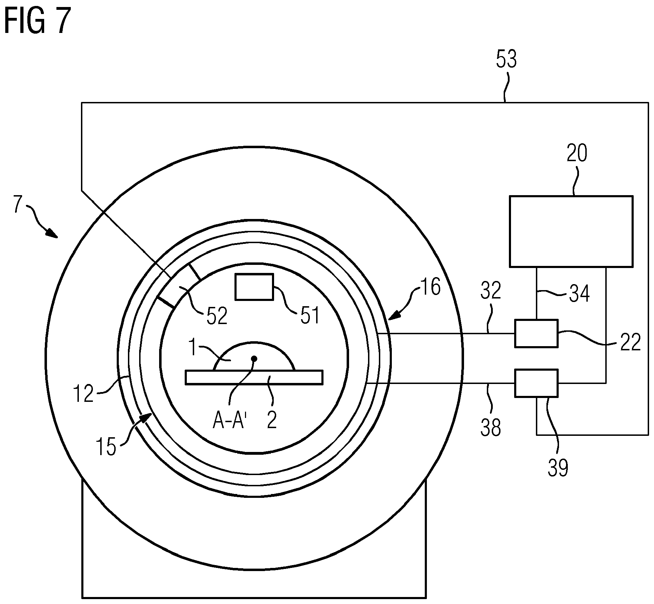

Fig. 7 zeigt eine schematische Darstellung einer Magnetresonanzanlage, welche eine Shimspulenvorrichtung 15 mit einem Bewegungssensor 52 umfasst. Hierbei kann der Bewegungssensor 52 vorzugsweise zur Erfassung einer, insbesondere translatorischen und/oder rotatorischen, Bewegung eines Objekts 51 relativ zur Shimspulenvorrichtung 15 ausgebildet sein. Bei der Erfassung einer Bewegung des Objekts 51 relativ zur Shimspulenvorrichtung 15 kann der Bewegungssensor 52 ein Signal 53 an den Verstärker 39 senden. Mittels der durch den Bewegungssensor 52 erfassten Bewegung kann ein Ausgleich der Grundmagnetfeldinhomogenitäten erster Ordnung durchgeführt werden. Dabei kann der Verstärker 39 beispielsweise mittels des Signals 53 von dem Bewegungssensor 52 eine Anpassung des ersten Shimprofils und/oder Speiseprofils vornehmen. Durch die Verwendung des Signals 53 des Bewegungssensors 52 kann vorzugsweise auf die Aufnahme einer Magnetfeldkarte zur Bestimmung der durch die Bewegung des Objekts 51 geänderte Grundmagnetfeldinhomogenität erster Ordnung verzichtet werden. Hierdurch kann eine Messdauer bei einer Untersuchung verringert werden.

In weiteren Ausbildungen der vorgeschlagenen Erfindung kann die Shimspulenvorrichtung mehrere Bewegungssensoren umfassen, wobei die Anordnung der Bewegungssensoren beispielsweise innerhalb der Gradientenspulenschicht 16 und/oder außerhalb der Magnetresonanzanlage vorteilhaft sein kann. Beispielsweise kann eine Bewegung eines Objekts 51 durch ein optisches Kamerasystem erfasst und zur Anpassung eines ersten Shimprofils und/oder Speiseprofils verwendet werden. Ferner kann der Bewegungssensor 52 an dem Objekt 51 angeordnet sein, um eine Bewegung des Objekts 51 relativ zur Shimspulenvorrichtung 15 zu erfassen. Der zumindest eine Bewegungssensor 52 kann dabei einen oder mehrere insbesondere optische und/oder mechanische und/oder elektromagnetische Sensoren umfassen.

Die in den beschriebenen Figuren enthaltenen schematischen Darstellungen bilden keinerlei Maßstab oder Größenverhältnis ab.

Es wird abschließend noch einmal darauf hingewiesen, dass es sich bei den vorhergehend detailliert beschriebenen Verfahren sowie bei den dargestellten Vorrichtungen lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden TeilKomponenten bestehen, die gegebenenfalls auch räumlich verteilt sein können.

## Patentansprüche

1. Magnetresonanzanlage (7), welche eine Shimspulenvorrichtung (15) und eine Gradientenspulenvorrichtung (12) umfasst, wobei die Shimspulenvorrichtung (15) dazu ausgebildet ist, Grundmagnetfeldinhomogenitäten erster Ordnung in einem Untersuchungsbereich (14) der Magnetresonanzanlage (7) auszugleichen,
wobei die Shimspulenvorrichtung (15) zumindest ein Shimspulenelement (41) umfasst,
wobei die Gradientenspulenvorrichtung (12) in einer Gradientenspulenschicht (16) angeordnet ist,
**dadurch gekennzeichnet, dass** in der Gradientenspulenschicht (16) zusätzlich zur Gradientenspulenvorrichtung (12) zumindest ein Teil des zumindest einen Shimspulenelements (41) angeordnet ist.

2. Magnetresonanzanlage (7) nach Anspruch 1, **dadurch gekennzeichnet, dass** die Shimspulenvorrichtung (15) und die Gradientenspulenvorrichtung (12) dazu ausgebildet sind, von einem gemeinsamen Verstärker (22) gespeist zu werden.

3. Magnetresonanzanlage (7) nach Anspruch 1, **dadurch gekennzeichnet, dass** die Shimspulenvorrichtung (15) und die Gradientenspulenvorrichtung (12) dazu ausgebildet sind, von jeweils einem separaten Verstärker (22,39) gespeist zu werden.

4. Magnetresonanzanlage (7) nach einem der Ansprüche 1 bis 3, **dadurch gekennzeichnet, dass** das zumindest eine Shimspulenelement (41) als Fingerabdruck-Spule ausgebildet ist.

5. Magnetresonanzanlage nach einem der vorangehenden Ansprüche, **dadurch gekennzeichnet, dass** die Shimspulenvorrichtung (15) mehrere gleiche Shimspulenelemente (41) umfasst.

6. Magnetresonanzanlage (7) nach einem der Ansprüche 2 bis 5, **dadurch gekennzeichnet, dass** die Shimspulenvorrichtung (15) mehrere Shimspulenelemente (41) umfasst,
wobei die mehreren Shimspulenelemente (41) dazu ausgebildet sind, über jeweils einen Kanal des die Shimspulenvorrichtung (15) speisenden Verstärkers gespeist zu werden.

7. Magnetresonanzanlage (7) nach Anspruch 6, **dadurch gekennzeichnet, dass** die mehreren Shimspulenelemente (41) n-fach rotationssymmetrisch um eine Längsachse des Untersuchungsbereiches (41) der Magnetresonanzanlage (7) herum angeordnet sind,
wobei n eine natürliche Zahl größer 1 ist.

8. Magnetresonanzanlage (7) nach einem der Ansprüche 6 bis 7, **dadurch gekennzeichnet, dass** jedes der mehreren Shimspulenelemente (41) dazu ausgebildet ist, jeweils einen Term einer Kugelflächenzerlegung der Grundmagnetfeldinhomogenitäten erster Ordnung auszugleichen.

9. Magnetresonanzanlage (7) nach einem der Ansprüche 6 bis 7, **dadurch gekennzeichnet, dass** jeweils mehrere zusammenwirkende Shimspulenelemente (41) dazu ausgebildet sind, jeweils zumindest anteilig mehrere Terme einer Kugelflächenzerlegung der Grundmagnetfeldinhomogenitäten erster Ordnung auszugleichen.

10. Magnetresonanzanlage (7) nach einem der Ansprüche 6 bis 9, **dadurch gekennzeichnet, dass** die Shimspulenvorrichtung (15) mehrere Speisepunkte (SP) umfasst, die jeweils mit einem der mehreren Shimspulenelemente (41) elektrisch verbunden sind,
wobei die mehreren Speisepunkte (SP) entlang eines Umfangs innerhalb der Gradientenspulenschicht (16) angeordnet sind, wobei die Magnetresonanzanlage (7) mehrere Kontaktflächen (KF) umfasst, die jeweils mit einem der mehreren Kanäle des Verstärkers elektrisch verbunden sind,
wobei die mehreren Kontaktflächen (KF) entlang des Umfangs innerhalb der Gradientenspulenschicht (16) angeordnet sind, wobei jeder Speisepunkt (SP) jeweils eine Kontaktfläche (KF) elektrisch kontaktiert,
wobei die Shimspulenvorrichtung (15) dazu ausgebildet ist, Grundmagnetfeldinhomogenitäten erster Ordnung auszugleichen, welche durch eine Rotationsbewegung (50) eines starr mit der Anordnung von Kontaktflächen (KF) verbundenen, insbesondere ferromagnetischen, Objekts (51) relativ zur Shimspulenvorrichtung (15), um eine Längsachse (A-A') des Untersuchungsbereiches (14) der Magnetresonanzanlage (7) herum, entsteht.

11. Magnetresonanzanlage (7) nach einem der vorangehenden Ansprüche, **dadurch gekennzeichnet, dass** die Shimspulenvorrichtung (15) zumindest einen Bewegungssensor (52) umfasst, der dazu ausgebildet ist, eine Bewegung eines, insbesondere ferromagnetischen, Objektes (51) relativ zur Shimspulenvorrichtung (15) zu erfassen, wobei die Shimspulenvorrichtung (15) dazu ausgebildet ist, mittels der durch den zumindest einen Bewegungssensor (52) erfassten Bewegung einen Ausgleich der Grundmagnetfeldinhomogenitäten erster Ordnung durchzuführen.

12. Verfahren zum Ausgleich von Grundmagnetfeldinhomogenitäten erster Ordnung in einem Untersuchungsbereich (14) einer Magnetresonanzanlage (7),
wobei die Magnetresonanzanlage (7) eine Shimspulenvorrichtung (15) und eine Gradientenspulenvorrichtung (12) umfasst, wobei die Shimspulenvorrichtung (15) zumindest ein Shimspulenelement (41) umfasst,
wobei die Gradientenspulenvorrichtung (12) in einer Gradientenspulenschicht (16) angeordnet ist,
wobei in der Gradientenspulenschicht (16) zusätzlich zur Gradientenspulenvorrichtung (12) das zumindest eine Shimspulenelement (41) angeordnet ist,
wobei die Grundmagnetfeldinhomogenitäten erster Ordnung durch eine Bestromung der Shimspulenvorrichtung (15) ausgeglichen werden.

13. Verfahren nach Anspruch 12, **dadurch gekennzeichnet, dass** die Shimspulenvorrichtung (15) und die Gradientenspulenvorrichtung (12) von einem gemeinsamen Verstärker gespeist werden.

14. Verfahren nach Anspruch 12, **dadurch gekennzeichnet, dass** die Shimspulenvorrichtung (15) und die Gradientenspulenvorrichtung (12) von jeweils einem separaten Verstärker (22,39) gespeist werden.

15. Verfahren nach einem der Ansprüche 12 bis 14, **dadurch gekennzeichnet, dass** die Shimspulenvorrichtung (15) mehrere Shimspulenelemente (41) umfasst, wobei die mehreren Shimspulenelemente (41) über jeweils einen Kanal des die Shimspulenvorrichtung (15) speisenden Verstärkers gespeist werden.

16. Verfahren nach Anspruch 15, **dadurch gekennzeichnet, dass** mittels jedes der mehreren Shimspulenelemente (41) jeweils einen Term einer Kugelflächenzerlegung der Grundmagnetfeldinhomogenitäten erster Ordnung ausgeglichen wird.

17. Verfahren nach Anspruch 15, **dadurch gekennzeichnet, dass** mittels jeweils mehrere zusammenwirkende Shimspulenelemente (41) jeweils zumindest anteilig mehrere Terme einer Kugelflächenzerlegung der Grundmagnetfeldinhomogenitäten erster Ordnung ausgeglichen werden.

18. Verfahren nach einem der Ansprüche 15 bis 17, **dadurch gekennzeichnet, dass** die Shimspulenvorrichtung (15) mehrere Speisepunkte (SP) umfasst, die jeweils mit einem der mehreren Shimspulenelemente (41) elektrisch verbunden sind,
wobei die mehreren Speisepunkte entlang eines Umfangs innerhalb der Gradientenspulenschicht (16) angeordnet sind,
wobei die Magnetresonanzanlage (7) mehrere Kontaktflächen (KF) umfasst, die jeweils mit einem der mehreren Kanäle des Verstärkers elektrisch verbunden sind,
wobei die mehreren Kontaktflächen (KF) entlang des Umfangs innerhalb der Gradientenspulenschicht (16) angeordnet sind, wobei jeder Speisepunkt (SP) jeweils eine Kontaktfläche (KF) elektrisch kontaktiert,
wobei die Grundmagnetfeldinhomogenitäten erster Ordnung, welche mittels einer Rotationsbewegung (50) eines starr mit der Anordnung von Kontaktflächen (KF) verbundenen, insbesondere ferromagnetischen, Objekts (51) relativ zur Shimspulenvorrichtung (15), um eine Längsachse (A-A') des Untersuchungsbereiches (14) der Magnetresonanzanlage (7) herum, entsteht, durch die Shimspulenvorrichtung (15) ausgeglichen wird.

19. Verfahren nach einem der Ansprüche 12 bis 18, **dadurch gekennzeichnet, dass** die Shimspulenvorrichtung (15) zumindest einen Bewegungssensor (52) umfasst,
wobei mittels des Bewegungssensors (52) eine Bewegung eines, insbesondere ferromagnetischen, Objektes (51) relativ zur Shimspulenvorrichtung (15) erfasst wird,
wobei mittels der Shimspulenvorrichtung (15) und der durch den zumindest einen Bewegungssensor (52) erfassten Bewegung ein Ausgleich der Grundmagnetfeldinhomogenitäten erster Ordnung durchgeführt wird.

20. Computerprogrammprodukt, welches ein Programm umfasst und direkt in einen Speicher einer programmierbaren Recheneinheit einer Verarbeitungseinheit ladbar ist, mit Programmmitteln, um ein Verfahren nach einem der Ansprüche 12 bis 19 auszuführen, wenn das Programm in der Recheneinheit der Verarbeitungseinheit ausgeführt wird.

# FIG 1

FIG 2

FIG 3

# FIG 4

41

15

41

41

41

41

41

41

41

K1

K2

K3

Kn

...

39

FIG 5

FIG 6

FIG 7

Europäisches
Patentamt

European
Patent Office

Office européen
des brevets

# EUROPÄISCHER RECHERCHENBERICHT

**Nummer der Anmeldung**

EP 19 17 4823

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2013/147476 A1 (SHVARTSMAN SHMARYU [US] ET AL) 13. Juni 2013 (2013-06-13) * Absätze [0005] - [0007], [0029] - [0068], [0076] - [0083]; Abbildungen 2a,3-11 * | 1-20 | INV. G01R33/3875 G01R33/385 G01R33/48 |
| | ----- | | |
| X | WO 2006/088453 A1 (ZHAO LEI [MA]; TEKLEMARIAM GRUM [US]; LIAN JIANYU [US]) 24. August 2006 (2006-08-24) * Seite 9, Absatz 2; Abbildung 1 * | 1,3,12, 14,20 | |
| | ----- | | |
| A | JUCHEM C ET AL: "Magnetic field modeling with a set of individual localized coils", JOURNAL OF MAGNETIC RESONANCE, ACADEMIC PRESS, ORLANDO, FL, US, Bd. 204, Nr. 2, 1. Juni 2010 (2010-06-01), Seiten 281-289, XP027060856, ISSN: 1090-7807 [gefunden am 2010-03-11] * Zusammenfassung * * chapter 1. Introduction, 2. methods, 3.4, and 4. discussion; Abbildungen 1, 2 * | 3,5-11, 14-18 | |
| | ----- | | **RECHERCHIERTE SACHGEBIETE (IPC)** |
| | | | G01R |

Der vorliegende Recherchenbericht wurde für alle Patentansprüche erstellt

| Recherchenort | Abschlußdatum der Recherche | Prüfer |
|---|---|---|
| München | 5. Dezember 2019 | Faber-Jurk, Sonja |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 19 17 4823

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-12-2019

| Im Recherchenbericht angeführtes Patentdokument | Datum der Veröffentlichung | Mitglied(er) der Patentfamilie | Datum der Veröffentlichung |
|---|---|---|---|
| US 2013147476 A1 | 13-06-2013 | AU 2012363783 A1 | 03-07-2014 |
| | | AU 2017203614 A1 | 15-06-2017 |
| | | CA 2858217 A1 | 11-07-2013 |
| | | CN 104204837 A | 10-12-2014 |
| | | CN 107300680 A | 27-10-2017 |
| | | EP 2791694 A1 | 22-10-2014 |
| | | HK 1202632 A1 | 02-10-2015 |
| | | JP 6253592 B2 | 27-12-2017 |
| | | JP 2015500127 A | 05-01-2015 |
| | | JP 2018075383 A | 17-05-2018 |
| | | US 2013147476 A1 | 13-06-2013 |
| | | US 2015185300 A1 | 02-07-2015 |
| | | US 2017176556 A1 | 22-06-2017 |
| | | WO 2013103477 A1 | 11-07-2013 |
| WO 2006088453 A1 | 24-08-2006 | KEINE | |

Für nähere Einzelheiten zu diesem Anhang : siehe Amtsblatt des Europäischen Patentamts, Nr.12/82